# EUROPEAN PATENT APPLICATION

(11) **EP 1 028 520 A1**
(43) Date of publication of application: **16.08.2000**
(21) Application number: 96929546.8
(22) Date of filing: 06.09.1996
(51) Int. Cl.: H02M 7/48, H01L 25/04, H01L 25/07, H01L 25/11

(54) **SEMICONDUCTOR DEVICE**

(71) Applicant: Hitachi, Ltd., Chiyoda-ku, Tokyo 101 (JP)
(72) Inventor: TANBA, Akihiro, Ibaraki 310 (JP); YAMADA, Kazuji, Ibaraki 316 (JP); OGAWA, Toshio, Ibaraki 312 (JP); SAITO, Ryuichi, Ibaraki 319-12 (JP); SHIGEMURA, Tatsuya, Ibaraki 312 (JP)
(74) Representative: Strehl Schübel-Hopf & Partner
(86) International application number: JP9602541
(87) International publication number: WO9810508

(57) **Abstract**

A semiconductor device comprising a metal substrate, a plurality of wires fixed to the metal substrate with an insulating layer interposed therebetween, and a power circuit connected electrically to the plurality of wires. The power circuit has a plurality of circuit portions connected electrically between the wires. The circuit portions have a plurality of terminals integral therewith, the terminals being bonded to a plurality of wires. The inventive semiconductor device constitutes a power semiconductor module of high reliability fabricated at low cost.

## Description

### TECHNICAL FIELD

The present invention relates to a module type semiconductor device constituting part of a power converter such as an inverter.

### BACKGROUND ART

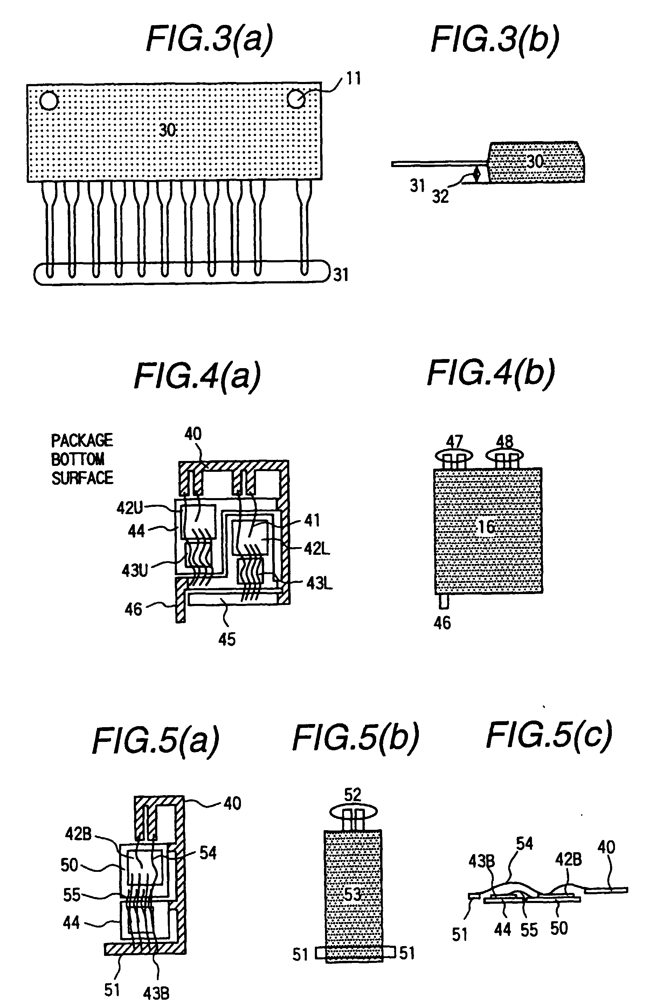

One way of reducing the cost of fabricating power semiconductor modules is the use of transfer molding in forming packages, as is the case with IC packages. One such power semiconductor module, shown in Figs. 3(a) and 3(b), is disclosed illustratively by Japanese Published Examined Patent Application No. Hei 6-80748. The disclosed module constitutes a three-phase inverter module made of Darlington-connected bipolar transistors. Figs. 3(a) and 3(b) are a plan view and a side view respectively of a package 30. The transfer mold type power semiconductor module has its packages formed using a mold. In that setup, external I/O terminals 31 extend from the package side.

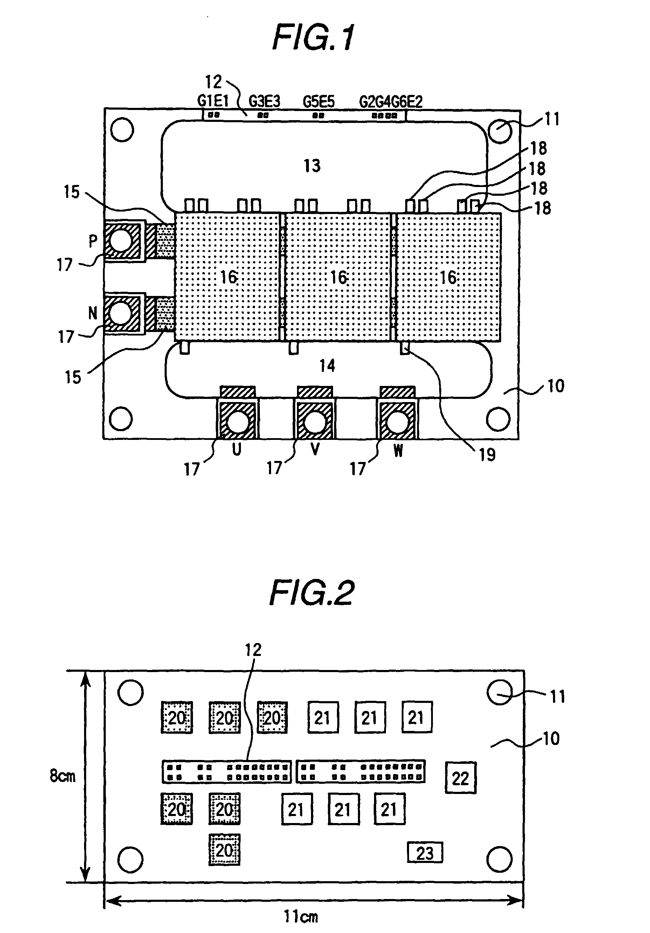

Another conventional power module employing transfer-molded packages is shown in Fig. 2. This module, as with the preceding one, is a three-phase inverter module. The module of Fig. 2 comprises bipolar transistor one-chip packages 20 and flywheel diode (FWD) one-chip packages 21. The packages 20 and 21 are soldered to a copper wire on an insulating metal substrate 10. The input of control signals and the output of a main current are conducted through a bottom entry connector 12 located in the middle of the module. This module also includes a three-terminal regulator 22 and a shunt resistor 23. The insulating metal substrate 10 has module mounting holes 11 through which the module is fasten to fins.

One advantage of the module shown in Figs. 3(a) and 3(b) is that it is small in size. A package dimension 32 shown in Fig. 3(b) is only a few millimeters. This means that the module is for use in small-capacity applications. If the package is adapted to a module with medium- to large-capacity requiring tens of amperes and 600V or more, the insulation distance between the fins to which the module is attached and the terminal to which a high voltage is applied will have to be secured by the dimension 32 measuring a few millimeters in Fig. 3(b). As a result, certain ambient conditions can trigger electrical discharges making it impossible to ensure reliability. To enhance reliability requires that the package dimension 32 need to be about one centimeter for the 600V class; accordingly the requirement cancels out the advantage of smallness for the module. If all devices are collectively transfer-molded as in the case of the above module, the module is subject to greater stress than a one-chip package application. If the power module in question is to be used in an environment where heating and cooling are repeated, increased stress can damage soldered parts inside thereby degrading module reliability.

In the three-phase inverter module of Fig. 2, the current capacity of its bipolar transistors is about 10A. In other words, the current capacity of the inverter amounts to 10-odd amperes at most. On the other hand, the insulating metal substrate 10 determining the module size is substantially equal to or larger than a three-phase inverter module of the 100A class adopting a module casing formed by using an injection molding case. That is, despite the fact that the current capacity is smaller by one order of magnitude, the module size remains about the same. The reason for this is that a three-phase inverter module comprising numerous elements in one-chip packages has a total package area greater than all semiconductor chip areas combined, and that complicated wiring arrangements degrade area efficiency. A metal base serving as a heat sink can warp progressively as the area gets wider. An increased warpage reduces adhesion between the metal base and the fins leading to a drop in module reliability.

There are demands for a large variety of power semiconductor modules: those offering current capacities large and small, those incorporating braking circuits, and those including converter circuits. To fabricate various types of the power module shown in Figs. 3(a) and 3(b) requires preparing a different package for each type. This can lead to a significant increase in production costs. With regard to the module in Figs. 3(a) and 3(b), there can be no repair work carried out after molding, therefore, a single faulty chip in the module renders the entire module useless.

It is therefore an object of the present invention to overcome the above and other deficiencies and disadvantages of the prior art and to provide a power semiconductor module of high reliability fabricated at low cost.

### DISCLOSURE OF INVENTION

In carrying out the invention and according to one aspect thereof, there is provided a semiconductor device comprising a metal substrate, a plurality of wires fixed to the metal substrate with an insulating layer interposed therebetween, and a power circuit connected electrically to the wires. The power circuit includes any one of various power converters such as an inverter device or a converter device. The power circuit has a plurality of circuit portions connected electrically between the wires. Illustratively, these circuit portions may correspond to one of phases of the inverter or converter device incorporated. The wires on the metal substrate may be constituted by supply voltage wirings (P wires) and ground potential wirings (N wires). The plurality of circuit portions have a plurality of terminals integral therewith, the terminals being connected electrically to the plurality of wires.

In a preferred structure according to the invention, the circuit portions may be incorporated in packages each covered with resin.

In another preferred structure according to the invention, the circuit portions may be interconnected electrically only through the wires on the metal substrate.

In a further preferred structure according to the invention, the power semiconductor device may be connected electrically to a wiring layer at the plurality of circuit portions and the plurality of terminals extending from the wiring layer.

The power semiconductor device may be any one of diverse semiconductor devices including insulated gate bipolar transistors, power MOSFETs, power transistors, thyristors and diodes, or the like.

According to the invention, a main circuit portion of the power circuit may be composed of a plurality of circuit portions each formed integrally. This makes it possible easily to increase or decrease the capacity or an AC phase count of the power converter device in accordance with an increased or decreased number of circuit portions mounted on the metal substrate. If a circuit portion of an additional circuit is suitably prepared and if that circuit portion is mounted as a single part on the metal substrate, it is easy to attach the additional circuit to the device. Thus the invention when implemented allows any of various types of power semiconductor module to be fabricated with ease by use of a relatively simple module structure. The result is a power semiconductor module of high reliability fabricated at low cost.

### BRIEF DESCRIPTION OF DRAWINGS

Fig. 1 is a schematic view showing a planar structure of an embodiment of the invention;
Fig. 2 is a schematic view of a conventional power module using one-chip packages;
Figs. 3(a) and 3(b) are a plan view and a side view respectively of a conventional transfer mold type power semiconductor module;
Figs. 4(a) and 4(b) are explanatory views showing an internal constitution of a basic package (2-in-1 type);
Figs. 5(a), 5(b) and 5(c) are explanatory views depicting an internal constitution of another basic package (braking circuit);
Figs. 6(a) and 6(b) are explanatory views illustrating an internal constitution of another basic package (converter circuit);
Figs. 7(a) and 7(b) are explanatory views indicating an internal constitution of a basic package (2-in-1 type) that uses a ceramic substrate;
Fig. 8 is an equivalent circuit diagram of a three-phase inverter module;
Fig. 9 is a schematic view of an aluminum insulating metal substrate;
Figs. 10(a) and 10(b) are a perspective view and a schematic cross-sectional view respectively of a main terminal block;
Fig. 11 is a schematic cross-sectional view of the embodiment of the invention;
Fig. 12 is a diagram showing an equivalent circuit of a three-phase inverter module incorporating a braking circuit;
Fig. 13 is a plane pattern view of another three-phase inverter module incorporating a braking circuit;
Fig. 14 is a diagram showing an equivalent circuit of a three-phase inverter module incorporating a converter circuit;
Fig. 15 is a schematic view of an example in which diode bridge packages and 2-in-1 packages are mounted on a single heat sink board;
Figs. 16(a) and 16(b) are schematic views of a dual package example embodying the invention;
Figs. 17(a) and 17(b) are schematic views showing a planar structure of a three-phase inverter module which incorporates a converter circuit and which uses basic packages (2-in-1 type) each having a ceramic substrate;
Fig. 18 is a schematic cross-sectional view of a module that utilizes a copper insulating metal substrate;
Fig. 19 is a schematic view of an intelligent power module embodying the invention;
Fig. 20 is a schematic view of another 2-in-1 package embodying the invention;
Figs. 21(a) and 21(b) are schematic views of another 2-in-1 package embodying the invention;
Figs. 22(a) and 22(b) are schematic views of another braking circuit package embodying the invention;
Figs. 23(a) and 23(b) are schematic views of a three-phase inverter module in which printed circuit boards are mounted on a metal substrate; and
Fig. 24 is a schematic view of a three-phase inverter module that employs the package shown in Fig. 20.

### BEST MODE FOR CARRYING OUT THE INVENTION

Preferred embodiments of this invention will now be described in detail with reference to the accompanying drawings.

### (First Embodiment)

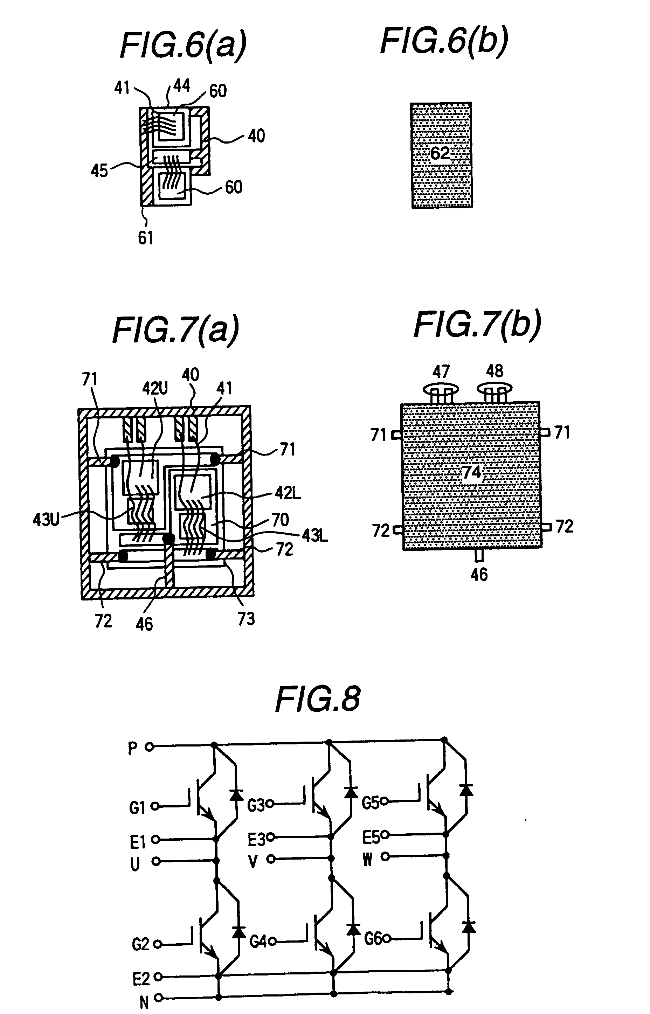

Described below with reference to Figs. 1, 4(a), 4(b), 8, 9, 10(a), 10(b) and 11 is a first embodiment of the invention constituting a three-phase inverter module whose equivalent circuit is shown in Fig. 8.

Fig. 1 is a schematic view showing a planar structure of the first embodiment. Three basic packages 16 are laid out on an aluminum insulating metal substrate 10. The number of basic packages 16 is equal to the number of AC output phases of the inverter circuit in use. If the number of phases is larger than three, the number of basic packages is raised correspondingly. Each basic package has what is known as a 2-in-1 (dual) structure having two insulated gate bipolar transistors (IGBT) and two flywheel diodes (FWD) to be transfer-molded. Each basic package 16 comprises control terminals 18 and an output terminal 19. Although not shown in Fig. 1, the bottom of each package is furnished with supply voltage wiring (P wire), ground potential wiring (N wire), and output wiring connected to the output terminal 19. The P, N and output wirings are connected to external terminals 17 by way of copper wires 15 on the aluminum insulating metal substrate 10. The copper wires 15 are formed illustratively by known printed wiring techniques on a resin layer covering the surface of the metal substrate.

Since the copper wires 15 are located immediately under the bottom of each package 16, they do not increase the module area. The control terminals 18 and the output terminal 19 are located separately on two sides flanking the package. Accordingly, a main circuit area 14 for causing a main current of the power semiconductor to flow and a control circuit area 13 for controlling the power semiconductor are also located on both sides of the packages 16. As a result, the control circuits are separated from the main circuit that handles high voltages and large currents, thereby realizing a module highly resistant to electrical noise.

Solder such as paste solder is used to make the following connections: the control terminals 18 with the control circuits 13; the output terminals 19 with the main circuit 14; the P, N and output wirings at the package bottom with the copper wires 15 on the aluminum insulating metal substrate 10; the control circuits 13 with a control terminal (bottom entry connector) 12; the main circuit 14 with output terminals U, V and W; and the P and N wires on the aluminum insulating metal substrate 10 with P and N terminals.

The first embodiment is designed to work on a rated voltage of 600V at a rated current of 100A. The module size (i.e., size of the aluminum insulating metal substrate 10) is approximately 10 cm × 7cm. That is, the module is smaller in size than the conventional example in Fig. 2 while boosting its current capacity by a factor of more than 10.

Fig. 4(a) is a schematic view showing an internal constitution of the basic package 16, and Fig. 4(b) is an external view of the same package. Two IGBTs 42U and 42L and two FWDs 43U and 43L constituting an upper arm and a lower arm are soldered onto a lead frame 40. The lead frame 40 is connected electrically to each chip through aluminum wires 41. In the first embodiment, each aluminum wire is 500 µm in diameter. With the current capacity of each wire taken into account, four wires are used to connect each chip. In the first embodiment, the wires are connected to aluminum electrodes of the semiconductor chip by ultrasonic welding. An emitter of the IGBT 42U (chip surface), an anode of the FWD 43U and output wiring 46 are connected by stitch bonding. Likewise, an emitter of the IGBT 42L, an anode of the FWD 43L and N wire 45 are connected by stitch wire bonding.

In the lead frame 40, the regions, except for those which are shaded, make up a package bottom. The shaded regions are elevated from the module bottom. In the illustrated makeup of the lead frame 40, P wire 44, the IGBT 42L, and the output wiring 46 under the FWD 43L constitute a module bottom bonded to a metal base that doubles as a thermal diffusion board. Of the output wirings 46, those extending out of the package to form output terminals are arranged not to constitute a module bottom. The arrangement is intended to let the N wires 45 be laid out continuously.

The transfer molding of the chip-mounted lead frame in Fig. 4(a), followed by cutting of the leads, provides a package whose external view is shown in Fig. 4(b). From the module side extend upper arm control terminals 47, lower arm control terminals 48 and the output terminal 46.

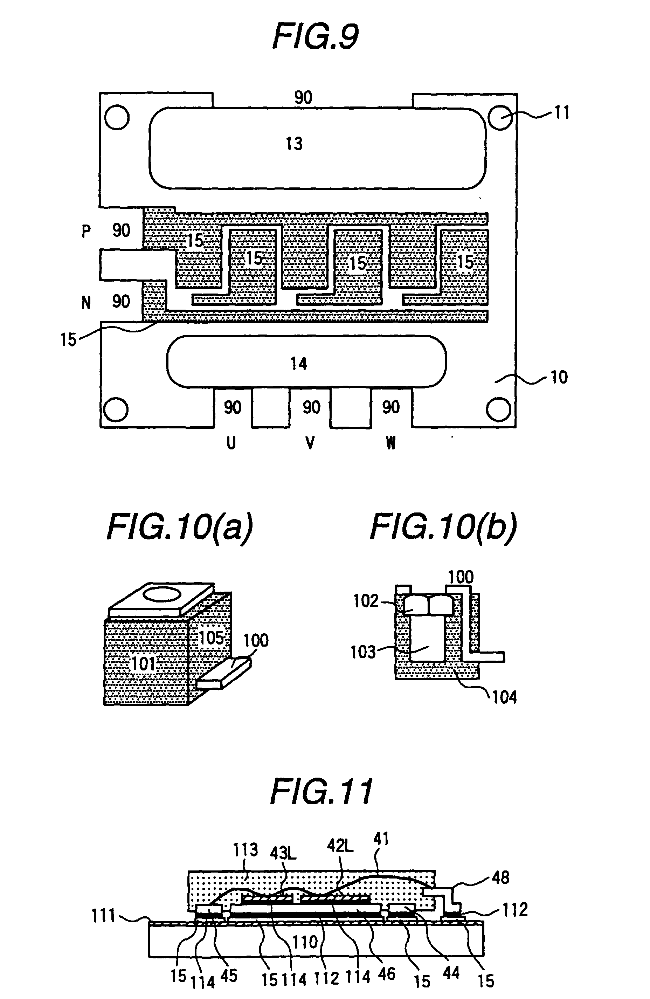

The main terminals 17 will now be described with reference to Figs. 10(a) and 10(b). Fig. 10(a) is a perspective view of a terminal block 101 constituting a main terminal 17, and Fig. 10(b) is a schematic cross-sectional view of the same block. With the first embodiment, the main terminals are fastened by screws in order to handle large currents. A copper plate 100 of one millimeter thick serving as a terminal and a nut 102 are formed by insert molding in a thermoplastic resin 104 such as phenylene sulfide (PPS). Under the nut 102 is a screw-accommodating recess 103. The copper plate 100 extends a few millimeters from a side 105 of the terminal block 101. The extended plate portion is soldered to internal circuit wiring. Thus the plate extension is elevated from the bottom of the terminal block 101 by an amount equal to the thickness of the aluminum insulating metal substrate 10. Although the first embodiment has been shown adopting the screw-based terminal fastening scheme, this is not limitative of the invention. A tab-based terminal arrangement may be used alternatively.

Fig. 9 shows an aluminum insulating metal substrate 10 in effect before the soldering of the basic packages 16, the main terminals 17 and control terminals 12. A notch 90 is formed on the periphery of the substrate. The main terminals 17 and control terminals 12 are placed in the notch and soldered thereto. The terminals may be bonded alternatively by silicon resin adhesive or the like to reinforce adhesiveness, if necessary. Besides the wiring for the control circuits 13 and the main circuit 14, the aluminum insulating metal substrate 10 has on its surface copper patterns 15 formed for use by the P, N and output wires (U, V, W). The 2-in-1 packages 16 are soldered onto the copper patterns 15. Holes 11 provided in the four corners of the aluminum insulating metal substrate 10 are used to fasten the substrate 10 that serves as a heat sink board onto fins. These holes are indispensable for fastening power semiconductor modules.

Fig. 11 is a schematic cross-sectional view showing a constitution of the first embodiment. As illustrated, the cross section comprises, from top to bottom of the package, a thermosetting resin 113 for transfer molding, semiconductor chips 42L and 43L, solder 114, a lead frame (output wiring) 46, paste solder 112, copper wire 15 on the aluminum insulating metal substrate, an insulating resin layer 111, and an aluminum base 110. The aluminum base 110 and the insulating resin layer 111 are 2 mm and 0.13 mm thick respectively. In this constitution, heat-related problems are eliminated because the heat generated by the semiconductor chips is released to the aluminum base 110 through the lead frame 46, copper wire 15 and the thinly formed insulating resin layer 111. When the basic packages 16 are bonded to the copper wire 15, the wiring layer is actually composed of two layers, i.e., of the lead frame 46 and copper wire 15. This makes it possible to reduce substantially the electrical resistance and inductance of the wiring involved. Whereas the N wire 15 alone has about 5 m Ω of resistance in the first embodiment, bonding the basic packages to the wiring reduces its resistance to around 0.3 m Ω. This is a nine-tenth reduction of the resistance. In order to reinforce insulation, the insulating metal substrate 10 may be covered with hard resin, silicon rubber or the like after the terminal blocks 17 and 12 as well as the packages 16 are mounted thereon. The covering should exclude the module-attaching holes 11.

### (Second Embodiment)

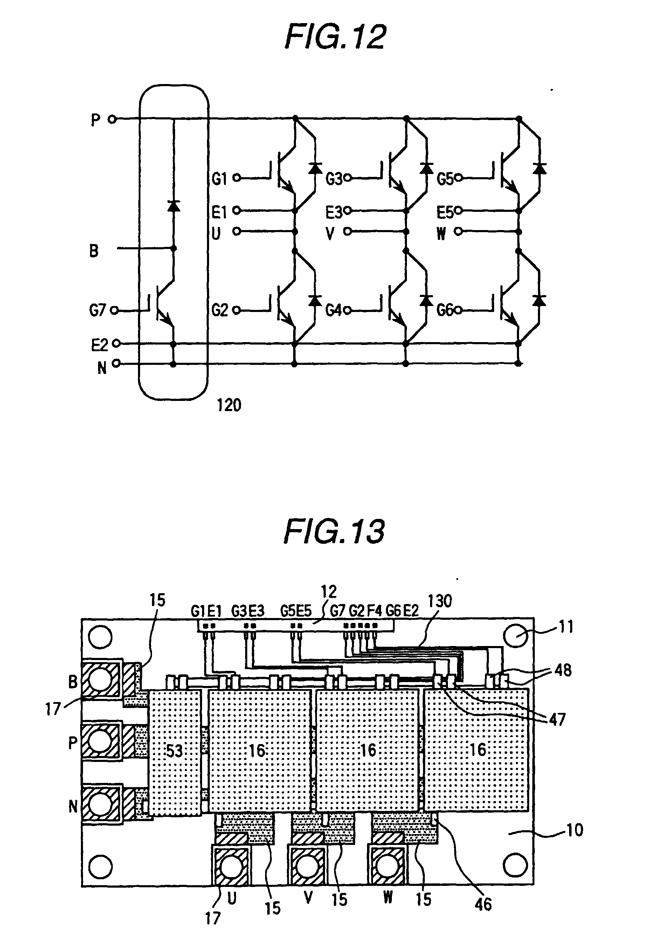

Described below with reference to Figs. 4(a), 4(b), 5(a), 5(b), 5(c) and 13 is a second embodiment of the invention constituting a three-phase inverter module incorporating a braking circuit serving as an equivalent circuit shown in Fig 12. An equivalent circuit of this inverter module is shown in Fig. 12. The second embodiment is characterized in that it has a braking circuit 120 of Fig. 12 inserted between the P and the N terminals of the three-phase inverter in Fig. 8. In the second embodiment, the 2-in-1 packages mentioned above are supplemented by the braking circuit 120 to form a single basic package. A typical braking circuit package is illustrated in Figs. 5(a) through 5(c). Fig. 5(a) is a schematic view showing an internal constitution of the braking circuit package, Fig. 5(b) is an external view of the same package, and Fig. 5(c) is a schematic cross-sectional view of the internal constitution of the package (resin excluded). An IGBT 42B and a diode 43B are soldered onto a lead frame. Aluminum wires are used to interconnect the chips and to connect these chips to the lead frame. The diameter of each aluminum wire and the wire count are the same as for the package of Figs. 4(a) and 4(b). In the lead frame, a braking terminal 50 and a P terminal 44 are located at a package bottom that serves as a thermal diffusion board. The package of Figs. 5(a) through 5(c) differs from the 2-in-1 package of Figs. 4(a) and 4(b) in terms of N wire 51. That is, whereas the package of Figs. 4(a) and 4(b) has its N wire 45 located at the package bottom, the package of the second embodiment has its N wire 51 elevated from the bottom by about one millimeter as shown in the cross-sectional view of Fig. 5(c). The reason for the elevation is attributable to how the aluminum wires are connected. With the second embodiment, different aluminum wires 54 and 55 are staggered in height but they use the same region when laid out. The wiring 55 ranging from the braking terminal 50 to the diode 43B is located under the wiring from the IGBT 42B to the N wires 51. This arrangement prevents the aluminum wires 54 and 55 from short-circuiting when the N wires 51 constitute part of the package bottom.

Fig. 13 is a plane pattern view of a three-phase inverter module incorporating a braking circuit made of a braking circuit package 53 in Figs. 5(a) through 5(c) and of a 2-in-1 package 16. This module is formed by supplementing the three-phase inverter module of Fig. 1 with a braking terminal B and the above-mentioned braking circuit package 53 on the side of the B, P and N terminals. Because the second embodiment does not include control circuits such as driver circuits, a control wiring region 14 is constituted only by copper wire 130 on the aluminum insulating metal substrate 10. The bottom entry connector comprising control terminals forms an eleven-terminal arrangement. For a current capacity of 100A, the module size is 11 cm × 6.5 cm. The terminal block structure and the way packages are bonded to the aluminum insulating metal substrate 10 are the same as with the first embodiment.

### (Third Embodiment)

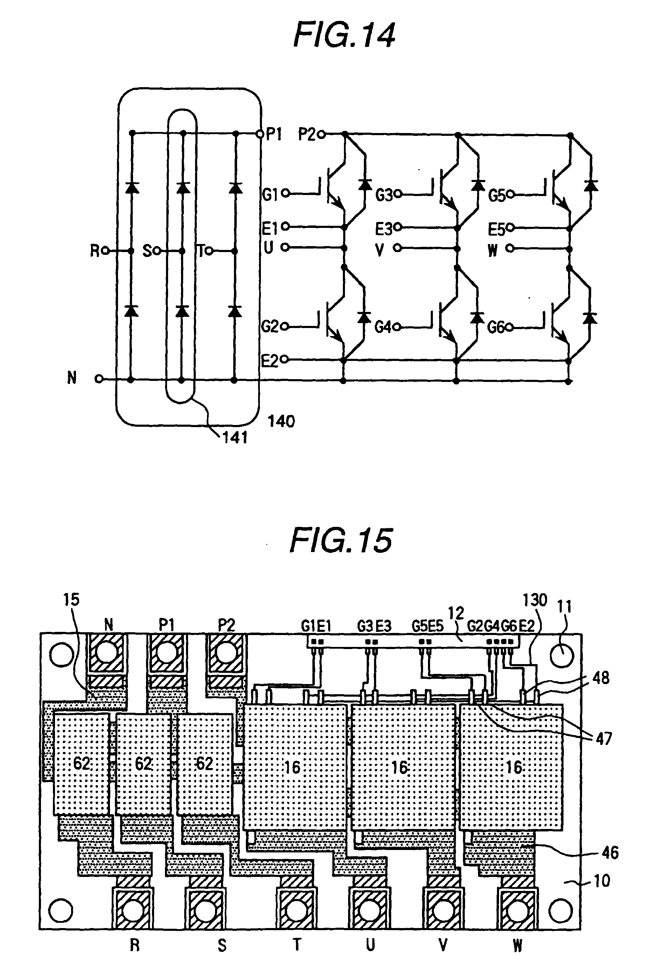

Described below with reference to Figs. 6(a), 6(b) and 15 is a third embodiment of the invention constituting a three-phase inverter module incorporating a converter circuit serving as an equivalent circuit of this inverter module is shown in Fig. 14.

A three-phase converter 140 shown in Fig. 14 is formed by diode bridges, each one of diode bridges making up a basic package. The arrangement makes it possible to apply the third embodiment not only to single-phase inverters but also to large-current modules in which diode bridges 141 are connected in parallel.

A diode bridge 141 is shown in Figs. 6(a) and 6(b). As illustrated in Fig. 6(a), two diodes 60 are soldered onto a lead frame 40, and aluminum wires connect the lead frame 40 to the diodes 60 electrically. In the third embodiment, all terminals (P44, N45, input 61) are located at the bottom of the package. As depicted in Fig. 6(b), no terminal projects from the periphery of a diode bridge package 62.

Fig. 15 shows an example in which packages 62 and 2-in-1 packages 16 are mounted on a single heat sink board. To the left of the group of 2-in-1 packages 16 are three diode bridge packages 62 for constituting a three-phase converter. On the aluminum insulating metal substrate, the package groups are flanked by AC output terminals R, S, T, U, V and W on one side and by DC voltage terminals N, P1 and P2 as well as a control terminal 12 on the other side. This structure is highly endurable against noise. The presence of the three diodes bridge packages 62 renders the shape of the module significantly oblong in shape; the module measures 13.5 cm × 7 cm.

### (Fourth Embodiment)

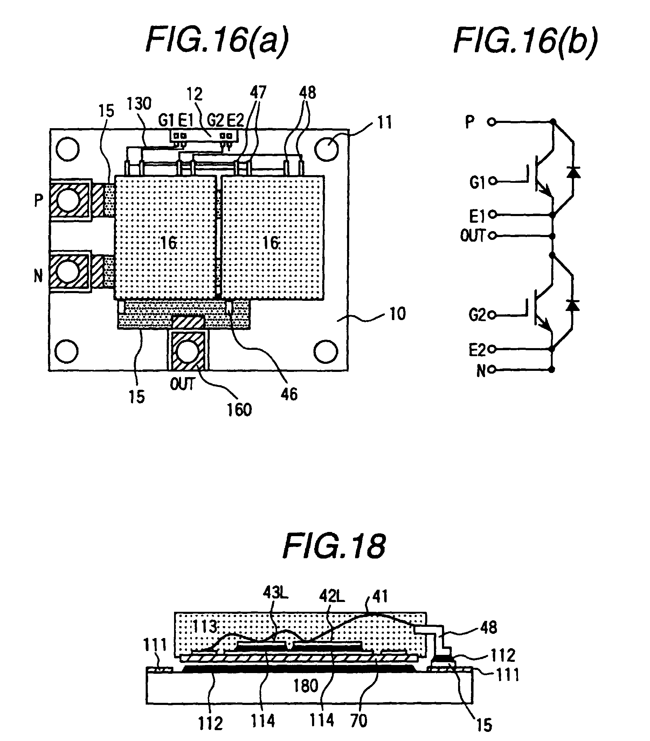

One advantage of this invention is its ability to have a given product fabricated in a variety of types at low cost. Figs. 16(a) and 16(b) show a fourth embodiment of the invention highlighting that advantage. The fourth embodiment, with its equivalent circuit shown in Fig. 16(b), is what is known as a dual package (2-in-1 package), in which a pair of switching elements are provided. Whereas the preceding embodiments were each shown having the current capacity of 100A, the fourth embodiment constitutes a 2-in-1 package offering a current capacity of 200A through the parallel connection of two 2-in-1 packages 16 each having 100A of current capacity. Because each basic package 16 comprises control terminals 47 and 48 as well as an output terminal 46, it is easy to implement parallel package connection. The fourth embodiment when carried out provides a variety of power semiconductor modules offering different current capacities. What needs to be heeded specifically in such cases is the difference in parasitic inductance between a control terminal 12 and an output terminal 160 on the one hand and each package on the other hand.

### (Fifth Embodiment)

In each of the preceding embodiments, packages each having a lead frame at the bottom were shown to be soldered to the copper wire 15 on the aluminum insulating metal substrate 10 for insulation purposes. One advantage of such a structure is its simplicity allowing the product in question to be fabricated at low cost. However, the structure is liable to develop higher thermal resistance than a constitution utilizing a ceramic substrate. The reason for this is that the thermal resistance of the insulating resin layer 111 is higher by at least one order of magnitude or more than that of ceramic-based setups. For example, when the lead frame serving as a thermal diffusion board is one millimeter in thickness, an IGBT chip with a current capacity of 100V has an actually measured thermal resistance of about 0.55°C/W, at least twice as high as that of an aluminum nitride substrate (ceramic substrate) having approximately 0.3°C/W of thermal resistance. The fifth embodiment is intended to forestall such an increase in thermal resistance, and is described below with reference to Figs. 7(a), 7(b), 17(a), 17(b) and 18.

Figs. 7(a) and 7(b) show a typical basic package that uses a ceramic substrate. An IGBT 42U and FWD 43U for an upper arm as well as an IGBT 42L and FWD 43L for a lower arm are soldered to a copper-plated ceramic substrate 70. Copper patterns on the ceramic are similar to those of the lead frame shown in Figs. 4(a) and 4(b). A lead frame 40 is soldered using solder 73 to the ceramic substrate 70 to which the semiconductor chips have been soldered. Soldered points are located on P wires 71, N wires 73 and an output terminal 46. The lead frame 40 is elevated from the copper-plated ceramic substrate 70 at the package bottom so that leads may extend laterally from package sides. Fig. 7(b) is an external view of the package. As illustrated, control terminals 47 and 48, p terminals 71, N terminals 72, and the output terminal 46 extend from the side walls of a 2-in-1 package 74. Because the package bottom is constituted by a ceramic substrate, all terminals are stretched out of the both side walls of the package. It is to be noted that the P and N terminals 71 and 72 extend from the package sides so that copper wires on the ceramic substrate may be connected to the copper wire 15 on the aluminum insulating metal substrate 10 whereby the P and N wires are connected.

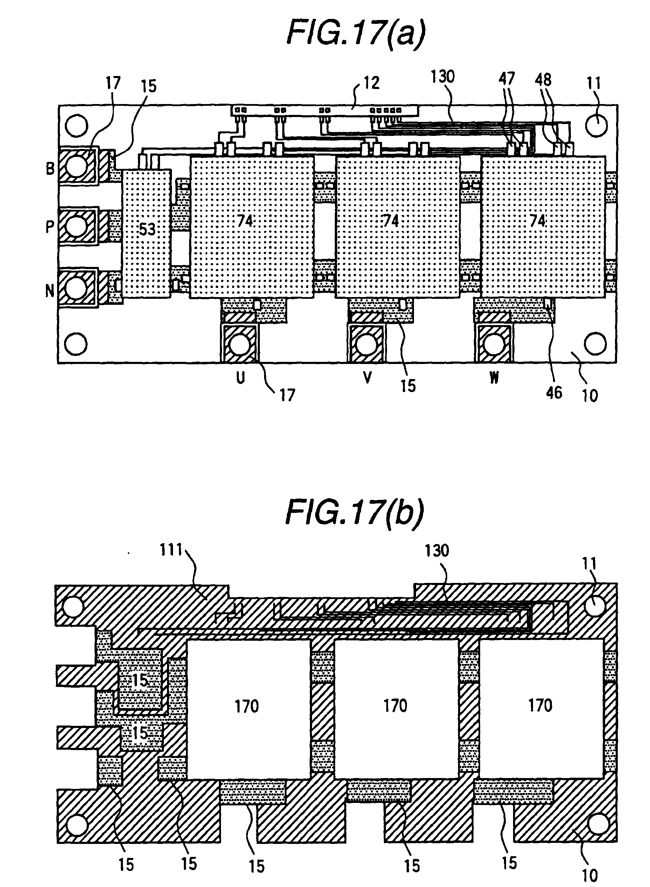

Figs. 17(a) and 17(b) show a braking circuit-equipped three-phase module which includes 2-in-1 packages described above along with the above-mentioned braking package 53.

Fig. 17(a) is a schematic plan view of the module. The module size is 14 cm × 6.5 cm, about 30 percent longer than the setup in Fig. 13 which measures 11 cm × 6.5 cm using the packages 16. The layout of the packages and the patterns of the control wirings 130 are the same as those of the second embodiment in Fig. 13.

Features of the fifth embodiment will now be described with reference to Fig. 17(b). The figure shows a plane pattern of the aluminum insulating metal substrate 10 in effect before the mounting of terminal blocks and packages 74. Those regions of the insulating resin layer 111 to which the basic packages 74 are to be soldered are etched so that metal surfaces of the aluminum base are exposed. The 2-in-1 packages 74 are soldered to the exposed regions 170. Specifically, the entire copper-plated ceramic substrate 70 at the bottom of each package 74 is soldered to the corresponding region. Copper wires serving as the P and N wire are located so as to flank the regions 170 from two sides, and the terminals 71 and 72 render the wires thereof electrically continuous. Although the fifth embodiment uses an aluminum insulating metal substrate, this is not limitative of the invention. Alternatively, a copper insulating metal substrate may be used which makes soldering easier than the aluminum insulating metal substrate. As in the setup of Fig. 13, the braking circuit of the fifth embodiment is located on the insulating resin layer 111. This is because the braking circuit generates less heat than the inverter portion and has little need to lower thermal resistance. The braking circuit may also be furnished in a package employing a ceramic substrate as in the case of Figs. 7(a) and 7(b).

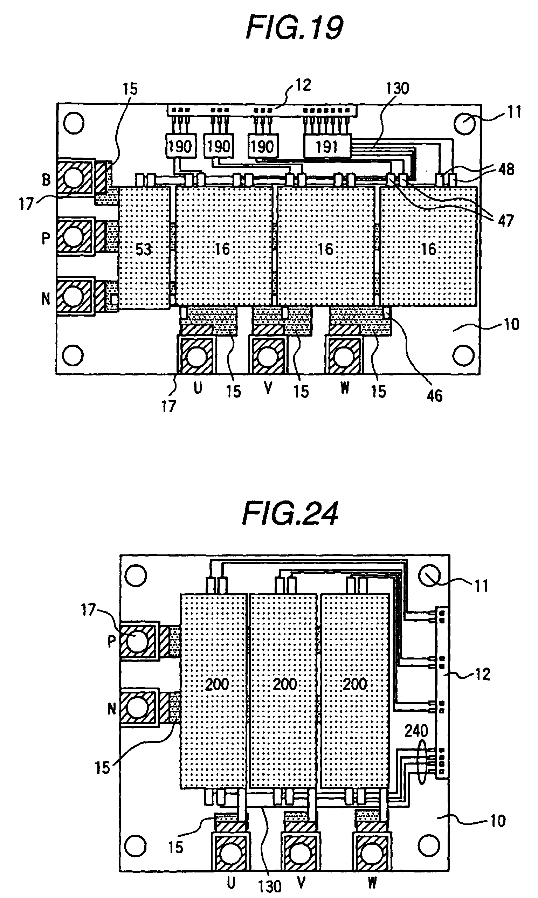

Fig. 18 is a schematic cross-sectional view showing a constitution of a module which is a variation of the fifth embodiment utilizing a copper insulating metal substrate. As illustrated, the cross section comprises, from top to bottom of the semiconductor chips (42L, 43L), silicon, solder 114, a ceramic substrate 70, solder 112, and a copper base. The setup has heat radiating system similar to those of a conventional power semiconductor module using a copper base. If an aluminum nitride substrate (ceramic substrate) of 0.635 mm in thickness is used, its thermal resistance amounts to 0.3°C/W, almost the same as that of the comparable conventional setup. In this variation, terminals (e.g., 48) are connected to the copper wire on the insulating resin layer 111.

### (Sixth Embodiment)

Fig. 19 shows an intelligent power module (IPM) practiced as a sixth embodiment of the invention incorporating switching elements together with their related driver and protective circuits. The module constitutes a three-phase inverter including a braking circuit. Also included are IC chips 190 for upper arm control and an IC chip 191 for lower arm and braking circuit control, the chips being transfer-molded and composed of driver and protective circuits.

In the preceding embodiments, the control circuit region 13 was shown to be made up of only copper wires on the insulating metal substrate. The sixth embodiment is characterized in that the control ICs including active circuits also reside in the control circuit region 13. The upper arm control IC arrangement is constituted by three chips to address three reference potential levels (output U, V, W) for upper arm control; there is only one lower arm control chip since the lower arm has a single reference potential level. The sixth embodiment when suitably implemented offers a simplified circuit constitution that promises enhanced reliability. However, that constitution is not limitative of the invention. Alternatively, four control circuit ICs of the above type may be used to make up one chip.

### (Variations of the First through the Sixth Embodiments)

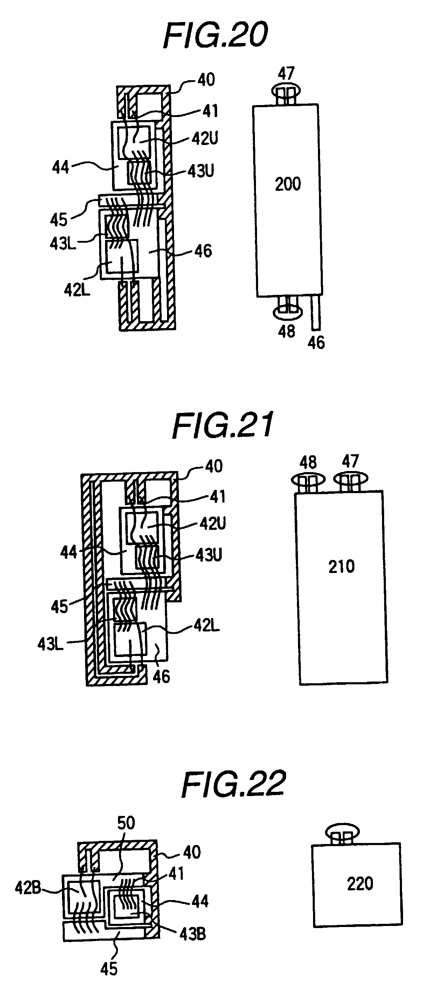

Variations of the above-described embodiments are outlined below with reference to Figs. 20, 21(a), 21(b), 22(a), 22(b), 23(a), 23(b) and 24.

Figs. 20, 21(a) and 21(b) show a variation of the 2-in-1 package, i.e., the basic package. In the lead frame of this variation, those parts making up P and N wires 44 and 45 are formed contiguously. The P and N wires arranged in such a pattern lower their self-inductance because of mutual inductance therebetween. Thus, the arrangement protects the P and N wires against causing noise from the output wiring subject to AC voltages.

Fig. 20 shows upper arm control terminals 47 and lower arm control terminals 48 extending from two opposite sides of the package. An output terminal 46 is made longer than the terminals 48 so that the terminal 46 will not be short-circuited with wires connected to the terminals 48. In the setup of Figs. 21(a) and 21(b), both the lower and the upper arm control terminals 48 and 47 are allowed to extend from the same side of the package by use of the lead frame. The output terminal is located at the bottom of the package.

Fig. 24 depicts a three-phase inverter module that uses packages shown in Fig. 20. In this variation of the invention, a control terminal 12 is located on a side opposite to that on which the P and N terminals are positioned. This setup makes the distance of wiring 240 for lower arm control almost the same as the wiring distance for upper arm control. That is, the inductance and resistance of the wiring involved are almost the same for upper and lower arm control. Consequently, switching actions of the switching elements for the upper and lower arms become substantially uniform.

Figs. 22(a) and 22(b) show a variation of the braking circuit. Unlike the embodiment in Figs. 5(a) through 5(c), this variation has its N wire 45 located at the package bottom.

The above-described variations of the invention all utilize an aluminum or copper insulating metal substrate.

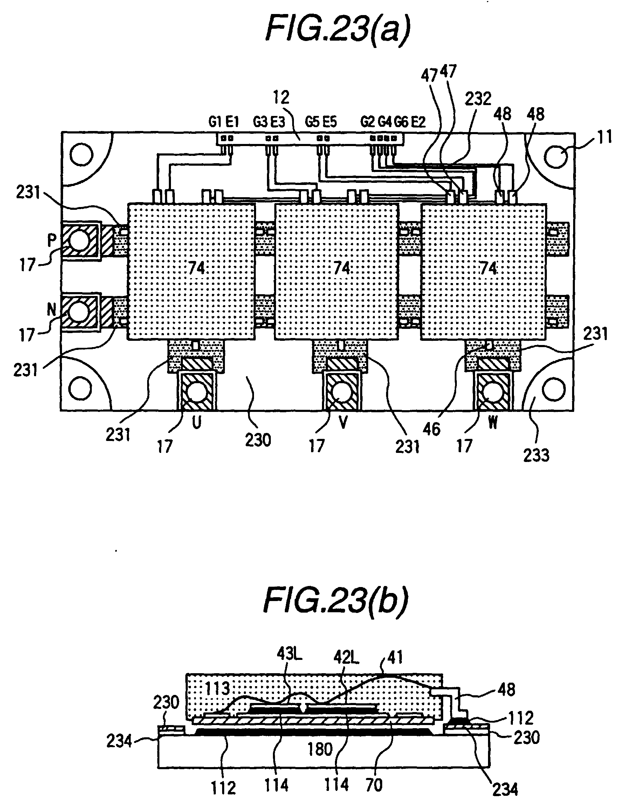

Fig. 23(a) is a schematic view showing a planar structure of a three-phase inverter module with a printed circuit board mounted on a metal substrate, and Fig. 23(b) is a schematic cross-sectional view showing a constitution of the same module. Because an insulating metal substrate is not used, the basic packages (2-in-1 type) must be of insulated type. For that reason, the module employs packages 74 shown in Figs. 7(a) and 7(b). A printed circuit board (PWB) 230 is bonded to a copper base 233 using silicon resin adhesive or the like. Main circuit wirings 231 and control wirings 232 are formed on the PWB 230. As with the preceding embodiments, this variation has a terminal-shaped notch formed where the terminals 17 and 12 are to be located. On the PWB 230, the portions for accommodating the basic packages 74 are hollowed out. The PWB 230 does not cover the parts where base-attaching holes 11 are to be formed. Thus fastening the PWB and the copper base together to fins with screws will not result in loose screws. With the screws securing the base tightly to the fins, the thermal resistance involved is reduced.

Fig. 23(b) is a cross-sectional view of the inverter module. Unlike the variation of the embodiment in Fig. 18, this module has its control terminals 48 soldered to copper patterns on the PWB 230. Heat radiating system of the module are similar to those of the variation in Fig. 18. In that sense, the module of Figs. 23(a) and 23(b) achieves a low-level thermal resistance similar to what is characteristic of comparable conventional power modules.

As described, the power module constitution according to the invention brings some basic structures common to a variety of module types into a single package structure. That structure makes it easy to mass-produce packages. This in turn allows power modules to be fabricated at low cost and permits easy repair work in case of any faulty package found after assembly.

## Claims

1. A semiconductor device comprising:
a metal substrate;
a plurality of wires fixed to said metal substrate with an insulating layer interposed therebetween; and
a power circuit including a power semiconductor device and connected electrically to said plurality of wires;
wherein said power circuit has a plurality of circuit portions connected electrically between said plurality of wires; and
wherein said plurality of circuit portions have a plurality of terminals integral therewith, said terminals being connected electrically to said plurality of wires.

2. A semiconductor device according to claim 1, wherein said plurality of circuit portions are incorporated in packages each covered with resin.

3. A semiconductor device according to claim 1, wherein said power semiconductor device is connected electrically to a wiring layer at said plurality of circuit portions, said plurality of terminals extending from said wiring layer.

4. A semiconductor device according to claim 3, wherein said plurality of circuit portions are incorporated in transfer-molded packages each covered with resin and wherein said wiring layer and said plurality of terminals are made from a lead frame.

5. A semiconductor device according to claim 3, wherein said wiring layer is formed on a ceramic substrate.

6. A semiconductor device according to claim 5, wherein said ceramic substrate is connected to an exposed metal surface of said metal substrate.

7. A semiconductor device according to claim 1, wherein said insulating layer is a resin layer bonded to a surface of said metal substrate.

8. A semiconductor device according to claim 1, wherein said insulating layer and said plurality of wires constitute a printed circuit board bonded to a surface of said metal substrate.

9. A semiconductor device according to claim 1, further comprising a plurality of external terminals connected electrically to said plurality of wiring layers on said metal substrate.

10. A semiconductor device according claim 1, wherein said plurality of wires are constituted by supply voltage and ground potential wirings.

11. A semiconductor device according to claim 1, wherein said power circuit includes an inverter circuit and wherein said plurality of circuit portions correspond to one of AC output phases of said inverter circuit, the number of said plurality of circuit portions being at least that which is determined by the number of said AC output phases.

12. A semiconductor device according to claim 11, wherein said power circuit further comprises a braking circuit and wherein said braking circuit constitutes one of said plurality of circuit portions.

13. A semiconductor device according to claim 1, wherein said power circuit includes a converter circuit.

14. A semiconductor device comprising:
a metal substrate;
a plurality of wires fixed to said metal substrate with an insulating layer interposed therebetween; and
a power circuit including a power semiconductor device and connected electrically to said plurality of wires;
wherein said power circuit has a plurality of circuit portions connected electrically between said plurality of wires; and
said plurality of wires to which said plurality of circuit portions are connected to have a resistance level lower than that is in effect when said plurality of circuit portions are not connected to said plurality of wires.
